# FASCICULE DE BREVET EUROPEEN

(11) **EP 4 554 346 B1**
(45) Date de publication et mention de la délivrance du brevet: **01.07.2026**
(21) Numéro de dépôt: 24211715.8
(22) Date de dépôt: 08.11.2024
(51) Int. Cl.: H05K 7/14

(54) **DISPOSITIF DE CONNEXION ÉLECTRIQUE**
ELEKTRISCHE VERBINDUNGSVORRICHTUNG
ELECTRICAL CONNECTING DEVICE

(30) Priorité: 09.11.2023 FR 2312233
(43) Date de publication de la demande: 14.05.2025
(73) Titulaire: Valeo eAutomotive Germany GmbH, 91056 Erlangen (DE)
(72) Inventeur: LARABI, Lakhdar, 95892 Cergy Pontoise (FR); THOMAS, Emil, 600130 Chennai, Tamil Nadu (IN); KOTA, Veeravenkatanagasudheer, 600130 Chennai, Tamil Nadu (IN)
(74) Mandataire: Valeo Powertrain Systems

(56) Documents cités:
- WO-A1-2018/046867
- CN-U- 204 634 148

## Description

La présente invention concerne un dispositif de connexion électrique configuré pour être assemblé avec un support d'un module électronique, notamment un onduleur. Cet onduleur peut être embarqué sur un véhicule automobile par exemple.

De l'art antérieur, on connaît le document WO 2018/046867 qui décrit un dispositif électrique et le document CN 204 634 148 qui décrit un circuit imprimé comprenant une structure résiliente.

Aussi, dans de nombreux modules électroniques, par exemple un onduleur qui équipe un véhicule automobile, il est utilisé des barreaux électriquement conducteurs, encore appelé « busbar » en anglais, associés par exemple à des phases électriques différentes. Il est pratique de prévoir ces barreaux conducteurs sur une pièce commune, ce qui facilite l'assemblage de ces barreaux conducteurs avec le reste du module électronique. Cette pièce comprend des zones de positionnement permettant son positionnement sur un support du module électronique. Lorsque cette pièce commune qui porte les barreaux conducteurs présente des dimensions relativement grandes, il peut se poser un problème d'assemblage dans le sens où une pièce de dimensions importantes exige que les zones de positionnement soient placées avec précision par rapport à des tiges de positionnement correspondante sur le support. Si une telle tolérance n'est pas respectée, alors l'assemblage de la pièce avec les barreaux électriques peut ne pas se faire correctement sur le reste du module électronique.

L'invention permet de surmonter cette difficulté.

L'invention a ainsi pour objet un dispositif de connexion électrique configuré pour être assemblé avec un support d'un module électronique, notamment un onduleur, ce dispositif de connexion électrique comportant un corps, en matière plastique, et des conducteurs électriques, notamment sous forme de barreaux conducteurs qui sont portés par le corps, le corps comportant au moins deux parties en plaque portant chacune l'un au moins des conducteurs, chaque partie en plaque comportant au moins une zone de positionnement du dispositif de connexion électrique sur le support, et ces parties en plaque étant liées entre elles par au moins une jonction élastiquement déformable de manière à permettre un placement de l'une des parties en plaque par rapport à l'autre partie avec un jeu, lorsque le dispositif de connexion électrique est assemblé sur le support du module électronique, la jonction élastiquement déformable étant formée par un pont de matière entre deux parties en plaque voisines, le pont de matière formant la jonction élastiquement déformable est adjacent à une fente qui sépare deux parties en plaque voisines, et cette fente permet notamment à ces deux parties en plaque voisines de se rapprocher ou de s'éloigner l'une de l'autre lorsque la zone de jonction élastiquement déformable est déformée.

Grâce à l'invention, le dispositif de connexion électrique qui est réalisé en plusieurs parties en plaque est moins soumis à des contraintes de tolérance. En effet, du fait de la jonction élastiquement déformable, les parties en plaque qui sont pourvues des zones de positionnement du dispositif de connexion électrique sur le support peut subir un déplacement relatif de l'une des parties en plaque par rapport à l'autre au moment de l'assemblage du dispositif de connexion électrique sur le support du module électronique. Ce déplacement relatif entre les parties en plaque permet de compenser l'impact de tolérances des différentes pièces de l'assemblage. L'invention permet ainsi par exemple de fabriquer le dispositif de connexion électrique et/ou le support du module électronique avec une tolérance acceptable en termes de procédé industriel. C'est la jonction élastiquement déformable qui permet de compenser ces tolérances avec un jeu entre les parties en plaque.

Selon l'un des aspects de l'invention, la zone de positionnement sur chaque partie en plaque comprend un orifice configuré pour le passage d'un organe de positionnement tel qu'une tige de positionnement qui permet de positionner la partie en plaque avec le support du module électronique.

Cette tige est par exemple de type métallique, liée au support du module électronique.

Selon l'un des aspects de l'invention, la tige de positionnement est simplement insérée dans l'orifice de la zone de positionnement. La tige de positionnement sert à un positionnement provisoire (et non une fixation finale) du dispositif de connexion électrique sur le support du module électronique.

Selon l'un des aspects de l'invention, toutes les zones de positionnement sur les parties en plaques sont formées par des orifices.

Selon l'un des aspects de l'invention, chaque partie en plaque comporte au moins deux zones de positionnement, notamment formées chacune par un orifice.

Selon l'un des aspects de l'invention, pour chaque partie en plaque, les zones de positionnement sont espacées l'une de l'autre suivant une direction de plus grande longueur de la partie en plaque.

Selon l'un des aspects de l'invention, le dispositif de connexion électrique comporte trois parties en plaque reliées entre elles, l'une à la suite de l'autre.

Ainsi le dispositif de connexion électrique peut comporter une partie en plaque placée entre les deux autres parties en plaque et étant reliée à ces parties en plaque par la jonction élastiquement déformable.

Le dispositif de connexion électrique comporte ainsi, dans ce cas, deux jonctions élastiquement déformables configurées chacune pour relier deux parties en plaque entre elles.

Selon l'un des aspects de l'invention, les parties en plaques sont placées de manière sensiblement coplanaire.

Autrement dit, les parties en plaques s'étendent sensiblement dans un même plan.

Selon l'un des aspects de l'invention, la jonction élastiquement déformable comporte un passage configuré pour être placé au droit d'une colonne creuse du support du module électronique.

Ceci permet d'introduire un organe de fixation, par exemple une tige telle qu'une vis, à travers la zone de jonction élastiquement déformable.

Selon l'un des aspects de l'invention, les parties en plaque peuvent ainsi comporter non seulement des orifices de positionnement mais également des passages pour par exemple des vis qui assurent le maintien final des parties en plaque sur le support du module électronique. Les parties en plaque peuvent ainsi coopérer avec des tiges de positionnement et des vis de fixation.

Selon l'un des aspects de l'invention, dans le cas où le dispositif de connexion électrique comporte trois parties en plaque, le dispositif de connexion comprend trois paires de zones de positionnement, chaque paire étant associée à l'une des parties en plaque.

Selon l'un des aspects de l'invention, un total de 6 zones de positionnement peut être prévu sur les parties en plaque.

Ce nombre de zones de positionnement représente un assemblage hyperstatique qui nécessite un positionnement précis des différentes zones de positionnement. Le fait de réaliser le dispositif de connexion électrique en plusieurs parties permet, grâce à des jeux possibles entre les différentes parties en plaque, de faire cet assemblage hyperstatique.

Selon l'un des aspects de l'invention, les parties en plaque sont au nombre de trois et sont disposées de manière à former un V ou un U.

Selon l'un des aspects de l'invention, les zones de jonction élastiquement déformables sont adjacentes à un bord intérieur du V ou du U.

L'invention permet ainsi aux branches du V ou du U de fléchir l'une vers l'autre.

Selon l'un des aspects de l'invention, le dispositif de connexion électrique présente une symétrie par rapport à un plan de symétrie, par exemple le plan de symétrie passe par la partie en plaque du milieu placée entre deux autres parties en plaque qui sont symétriques l'une de l'autre par rapport à ce plan de symétrie.

Selon l'un des aspects de l'invention, la fente est formée entre deux bords sensiblement parallèles des deux parties en plaque voisines.

Selon l'un des aspects de l'invention, le pont de matière présente une forme sensiblement circulaire avec en son centre un orifice traversant.

Selon un autre exemple de réalisation de l'invention, la jonction élastiquement déformable comporte plusieurs ponts de matière reliant deux parties en plaque voisine.

Selon l'un des aspects de l'invention, ces ponts de matière sont disposés à différents emplacement de bords en regard des deux parties en plaque voisines.

Les ponts de matière sont par exemple des bandes de matière pleines.

Selon l'un des aspects de l'invention, ces bandes de matière peuvent être relativement fines pour pouvoir être déformées sans se casser.

Le jeu permis par la jonction élastiquement déformable selon l'invention peut provenir, par exemple, d'une faible rotation relative de l'une des parties en plaque par rapport à l'autre.

Selon l'un des aspects de l'invention, la rotation relative peut atteindre par exemple un angle de 10 degrés au maximum, ou peut atteindre un angle de 5 degrés au maximum.

Selon l'un des aspects de l'invention, la jonction élastiquement déformable est formée à un coin de la partie en plaque de sorte à permettre un mouvement relatif entre deux parties en plaques voisines autour de la jonction élastiquement déformable, par exemple à la manière d'un pivot.

Selon l'un des aspects de l'invention, le dispositif de connexion électrique comporte en outre au moins un bloc de guidage pour guider des broches de signaux électriques.

Selon l'un des aspects de l'invention, ces broches de signaux électriques appartiennent au module électronique.

Selon l'un des aspects de l'invention, ce ou ces blocs de guidage sont formés par exemple par des barrettes avec des passages pour les broches, barrettes fixées sur les parties en plaque. Ce ou ces blocs de guidage sont par exemple réalisées par surmoulage, et/ou à base de résine.

Selon l'un des aspects de l'invention, les barreaux conducteurs sont noyés dans la masse des parties en plaque.

Les barreaux conducteurs sont notamment surmoulés par la matière plastique des parties en plaque.

Selon l'un des aspects de l'invention, les barreaux conducteurs présentent des extrémités de connexion qui débordent de la matière qui forme les parties en plaque.

L'invention concerne encore un module électronique, notamment un onduleur, comportant un dispositif de connexion électrique tel que décrit ci-dessus, configuré pour être assemblé avec un support du module électronique pour assurer le raccordement électrique des phases du module électronique, le support comprenant notamment des tiges de positionnement configurées pour coopérer avec des zones de positionnement des parties en plaque.

L'invention concerne encore un procédé d'assemblage d'un module électronique, notamment un onduleur, comportant un dispositif de connexion électrique tel que décrit ci-dessus, configuré pour être assemblé avec un support du module électronique pour assurer le raccordement électrique des phases du module électronique, le support comprenant notamment des tiges de positionnement configurées pour coopérer avec des zones de positionnement des parties en plaque, le procédé comportant l'étape suivante :
- placer les parties en plaque du dispositif de connexion électrique sur les tiges de positionnement du support, éventuellement en ajustant la position relative des parties en plaque pour que les tiges de positionnement soient en regard des zones de positionnement des parties en plaque.

D'autres caractéristiques, détails et avantages de l'invention ressortiront plus clairement à la lecture de la description qui suit d'une part, et de plusieurs exemples de réalisation donnés à titre indicatif et non limitatif en référence aux dessins schématiques annexés d'autre part, sur lesquels :
[Fig 1] La figure 1 est une représentation en perspective d'un module électronique selon l'invention ;
[Fig. 2] La figure 2 est une vue du dispositif de connexion électrique du module de la figure 1 ;
[Fig. 3] La figure 3 est une représentation en perspective du corps du dispositif de connexion électrique illustré sur les figures 1 et 2 ;
[Fig. 4] La figure 4 est une représentation, en coupe, du dispositif de connexion électrique de la figure 2 ;
[Fig. 5] La figure 5 est une représentation d'un dispositif de connexion électrique selon un autre mode de réalisation.

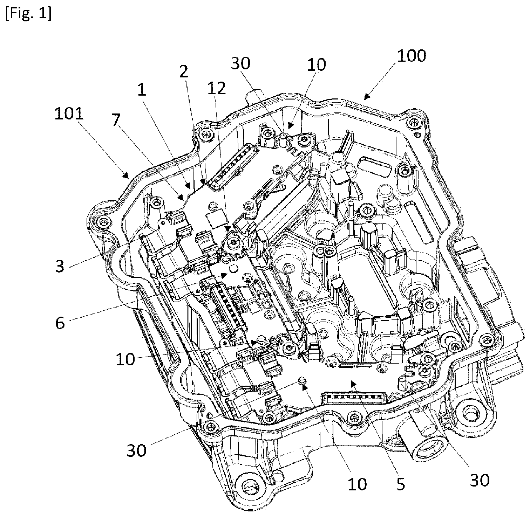

On a représenté, sur la figure 1, un module électronique 100 faisant partie d'un onduleur embarqué sur un véhicule automobile. L'onduleur sert à convertir le courant électrique continu fourni par une batterie en courant alternatif, dont le moteur électrique a besoin pour entraîner les roues.

Ce module électronique 100 comporte un dispositif de connexion électrique 1 selon un exemple de réalisation de l'invention, configuré pour être assemblé avec un support 101 du module électronique 100 pour assurer le raccordement électrique des phases du module électronique 100. Le support 101 se présente globalement sous la forme d'une demi-coquille dans le fond de laquelle est disposé le dispositif de connexion électrique 1.

Le support 101 comprend des tiges de positionnement 30 configurées pour coopérer avec des zones de positionnement 10 du dispositif de connexion électrique 1, comme on va le décrire en détails.

Le dispositif de connexion électrique 1 comporte un corps 2, ici en matière plastique, et des conducteurs électriques 3 sous forme de barreaux électriquement conducteurs (appelés « busbars » en anglais) qui sont portés par le corps 2.

Le corps 2 comporte trois parties en plaque 5, 6, 7 portant chacune des conducteurs 3.

Les parties en plaque 5, 6, 7 comportent des zones de positionnement 10 du dispositif de connexion électrique 1 sur le support 101, et ces parties en plaque 5, 6, 7 sont liées entre elles par des jonctions élastiquement déformables 12 de manière à permettre un placement de l'une des parties en plaque 5, 6, 7 par rapport à l'autre partie en plaque voisine avec un jeu, lorsque le dispositif de connexion électrique 1 est assemblé sur le support 101 du module électronique 100.

Dans l'exemple décrit, les trois parties en plaque 5, 6, 7 sont reliées entre elles, l'une à la suite de l'autre.

Ainsi la partie en plaque 6 est placée au milieu entre les deux autres parties en plaque 5 et 7 et étant reliée à ces parties en plaque 5 et 7 par deux jonctions élastiquement déformables 12, de chaque côté de la partie en plaque 6.

Le dispositif de connexion électrique comporte ainsi, dans ce cas, deux jonctions élastiquement déformables 12.

Les parties en plaques 5, 6, 7 sont placées de manière sensiblement coplanaire.

Autrement dit, les parties en plaques 5, 6, 7 s'étendent sensiblement dans un même plan.

Les zones de positionnement 10 sur les parties en plaque 5, 6, 7 comprennent chacune un orifice 17 configuré pour le passage d'une tige de positionnement 30 qui permet de positionner les parties en plaques 5, 6, 7 avec le support 101 du module électronique. Les zones de positionnement 10 sont par exemple au nombre de 2 par partie en plaque 5, 6, 7.

Chaque tige 30 est par exemple de type métallique, liée au support 101 du module électronique.

Chaque tige de positionnement 30 est simplement insérée dans l'orifice 17 de la zone de positionnement. La tige de positionnement 30 sert à un positionnement provisoire (et non une fixation finale) du dispositif de connexion électrique 1 sur le support 101 du module électronique.

Pour chaque partie en plaque 5, 6, 7, les zones de positionnement 10 sont espacées l'une de l'autre suivant une direction de plus grande longueur de la partie en plaque 5, 6, 7.

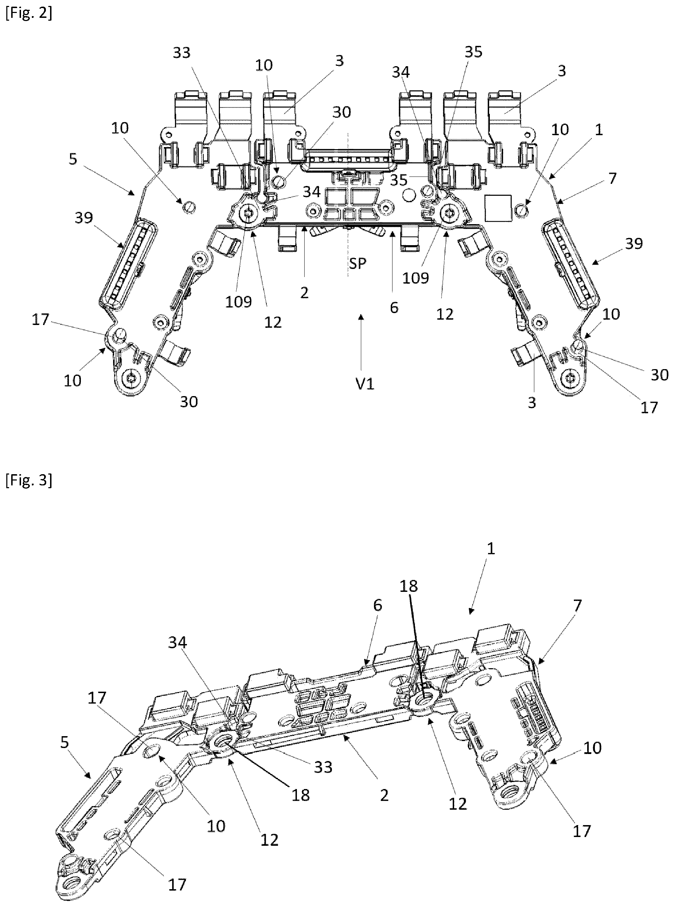

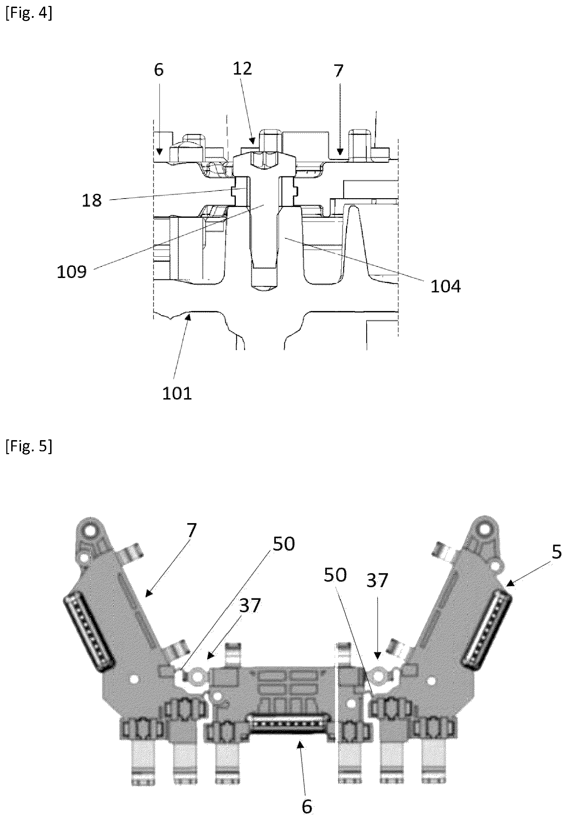

Comme visible sur la figure 4 qui est une vue suivant la flèche V1 de la figure 2, la jonction élastiquement déformable 12 comporte un passage 18 configuré pour être placé au droit d'une colonne creuse 104 du support 101 du module électronique.

Ceci permet d'introduire un organe de fixation, par exemple une tige telle qu'une vis 109, à travers le passage 18 de la zone de jonction élastiquement déformable 12. La vis 109 est vissée sur la colonne creuse 104 du support 101.

La jonction élastiquement déformable 12 joue ainsi un rôle de point de pivot entre deux parties en plaque voisines.

Les vis 109 assurent le maintien final des parties en plaque 5, 6, 7 sur le support 101 du module électronique. Les parties en plaque 5, 6, 7 peuvent ainsi coopérer avec des tiges de positionnement 30 et des vis de fixation 109.

La jonction élastiquement déformable 12 est formée par un pont de matière 33 entre deux parties en plaque voisines 5, 6, 7.

Les parties en plaque 5, 6, 7, au nombre de trois, sont disposées de manière à former un U (un U à trois branches formées par les trois parties en plaques). Les zones de jonction élastiquement déformables 12 permettent aux branches du U de fléchir l'une vers l'autre.

Le dispositif de connexion électrique 1 présente une symétrie par rapport à un plan de symétrie SP passant par la partie en plaque 6 du milieu placée entre deux autres parties en plaque 5 et 7.

Le pont de matière 33 formant la jonction élastiquement déformable 12 est adjacent à une fente 34 qui sépare deux parties en plaque voisines.

Cette fente 34 permet à ces deux parties en plaque voisines 5,6,7 de se rapprocher ou de s'éloigner l'une de l'autre lorsque la zone de jonction élastiquement déformable 12 est déformée.

La fente 34 est formée entre deux bords sensiblement parallèles 35 des deux parties en plaque voisines 5,6,7.

Dans un autre exemple de réalisation de l'invention illustrée à la figure 5, la jonction élastiquement déformable 37 comporte plusieurs ponts de matière 50 reliant deux parties en plaque voisine.

Ces ponts de matière 50 sont disposés à différents emplacement de bords en regard des deux parties en plaque voisines 5,6,7.

Les ponts de matière 50 sont par exemple des bandes de matière pleines.

Ces bandes de matière 50 peuvent être relativement fines pour pouvoir être déformées sans se casser.

Le jeu permis par la jonction élastiquement déformable 12 ; 37 selon l'invention peut provenir, par exemple, d'une faible rotation relative de l'une des parties en plaque 5,6,7 par rapport à l'autre.

La rotation relative peut atteindre par exemple un angle de 10 degrés au maximum, ou peut atteindre un angle de 5 degrés au maximum.

La jonction élastiquement déformable 12 ; 37 est formée à un coin de la partie en plaque 5,6,7 de sorte à permettre un mouvement relatif entre deux parties en plaques voisines autour de la jonction élastiquement déformable 12 ; 37, par exemple à la manière d'un pivot.

Le dispositif de connexion électrique 1 comporte en outre des blocs de guidage 39 pour guider des broches de signaux électriques. Ces broches de signaux électriques appartiennent au module électronique. Ce ou ces blocs de guidage 39 sont formés par exemple par des barrettes avec des passages pour les broches, barrettes fixées sur les parties en plaque. Ce ou ces blocs de guidage sont par exemple réalisées par surmoulage, et/ou à base de résine.

Les barreaux conducteurs 3 sont noyés dans la masse des parties en plaque 5,6,7.

Les barreaux conducteurs 3 sont notamment surmoulés par la matière plastique des parties en plaque 5,6,7, et présentent des extrémités de connexion qui débordent de la matière qui forme les parties en plaque 5,6,7.

## Revendications

1. Dispositif de connexion électrique (1) configuré pour être assemblé avec un support (101) d'un module électronique (100), notamment un onduleur, ce dispositif de connexion électrique (1) comportant un corps (2), en matière plastique, et des conducteurs électriques (3), notamment sous forme de barreaux conducteurs qui sont portés par le corps (2), le corps comportant au moins deux parties en plaque (5, 6, 7) portant chacune l'un au moins des conducteurs, chaque partie en plaque (5, 6, 7) comportant au moins une zone de positionnement (10) du dispositif de connexion électrique (1) sur le support (101), et ces parties en plaque (5, 6, 7) étant liées entre elles par au moins une jonction élastiquement déformable (12) de manière à permettre un placement de l'une des parties en plaque (5, 6, 7) par rapport à l'autre partie avec un jeu, lorsque le dispositif de connexion électrique (1) est assemblé sur le support (101) du module électronique, la jonction élastiquement déformable (12 ; 37) étant formée par un pont de matière (33 ; 50) entre deux parties en plaque voisines, le pont de matière formant la jonction élastiquement déformable est adjacent à une fente (34) qui sépare deux parties en plaque voisines, et cette fente permet notamment à ces deux parties en plaque voisines de se rapprocher ou de s'éloigner l'une de l'autre lorsque la zone de jonction élastiquement déformable est déformée.

2. Dispositif de connexion électrique (1) selon la revendication précédente, dans lequel la zone de positionnement (10) sur chaque partie en plaque comprend un orifice (17) configuré pour le passage d'un organe de positionnement tel qu'une tige de positionnement (30) qui permet de positionner la partie en plaque avec le support du module électronique, cette tige étant par exemple de type métallique, liée au support du module électronique.

3. Dispositif de connexion électrique (1) selon la revendication précédente, dans lequel chaque partie en plaque (5, 6, 7) comporte au moins deux zones de positionnement (10), notamment formées chacune par un orifice (17).

4. Dispositif de connexion électrique (1) selon l'une des revendications précédentes, dans lequel le dispositif de connexion électrique (1) comporte trois parties en plaque (5, 6, 7) reliées entre elles, l'une à la suite de l'autre, et deux jonctions élastiquement déformables (12 ; 37) configurées chacune pour relier deux parties en plaque entre elles.

5. Dispositif de connexion électrique (1) selon la revendication précédente, dans lequel la jonction élastiquement déformable (12 ; 37) comporte un passage (18) configuré pour être placé au droit d'une colonne creuse (104) du support (101) du module électronique.

6. Dispositif de connexion électrique (1) selon l'une des revendications précédentes, dans lequel la jonction élastiquement déformable comporte plusieurs ponts de matière (50) reliant deux parties en plaque voisine.

7. Dispositif de connexion électrique (1) selon l'une des revendications précédentes, dans lequel la jonction élastiquement déformable (12 ; 37) est formée à un coin de la partie en plaque de sorte à permettre un mouvement relatif entre deux parties en plaques voisines autour de la jonction élastiquement déformable, par exemple à la manière d'un pivot.

8. Dispositif de connexion électrique (1) selon l'une des revendications précédentes, dans lequel les barreaux conducteurs (3) sont notamment surmoulés par la matière plastique des parties en plaque.

9. Module électronique (100), notamment un onduleur, comportant un dispositif de connexion électrique (1) selon l'une des revendications précédentes, configuré pour être assemblé avec un support (101) du module électronique pour assurer le raccordement électrique des phases du module électronique, le support (101) comprenant notamment des tiges de positionnement configurées pour coopérer avec des zones de positionnement (10) des parties en plaque (5,6,7).

10. Procédé d'assemblage d'un module électronique (100), notamment un onduleur, comportant un dispositif de connexion électrique (1) selon l'une des revendications 1 à 8, configuré pour être assemblé avec un support (101) du module électronique pour assurer le raccordement électrique des phases du module électronique, le support comprenant notamment des tiges de positionnement (30) configurées pour coopérer avec des zones de positionnement des parties en plaque, le procédé comportant l'étape suivante :
- placer les parties en plaque (5,6,7) du dispositif de connexion électrique sur les tiges de positionnement (30) du support, éventuellement en ajustant la position relative des parties en plaque (5,6,7) pour que les tiges de positionnement soient en regard des zones de positionnement des parties en plaque.

## Patentansprüche

1. Elektrisches Verbindungsgerät (1), das so konfiguriert ist, dass es mit einem Träger (101) eines elektronischen Moduls (100), insbesondere eines Wechselrichters, zusammengebaut werden kann, wobei dieses elektrische Verbindungsgerät (1) einen Körper (2) aus Kunststoff und elektrische Leiter (3), insbesondere in Form von Leiterstäben, die von dem Körper (2) getragen werden, umfasst, wobei der Körper mindestens zwei Plattenteile (5, 6, 7) aufweist, die jeweils mindestens einen der Leiter tragen, wobei jedes Plattenteil (5, 6, 7) mindestens eine Positionierungszone (10) des elektrischen Verbindungsgeräts (1) auf dem Träger (101) aufweist und diese Plattenteile (5, 6, 7) durch mindestens eine elastisch verformbare Verbindung (12) miteinander verbunden sind, um eine Platzierung eines der Plattenteile (5, 6, 7) relativ zu dem anderen Teil mit einem Spiel zu ermöglichen, wenn das elektrische Verbindungsgerät (1) auf dem Träger (101) des elektronischen Moduls montiert ist, wobei die elastisch verformbare Verbindung (12; 37) durch eine Materialbrücke (33; 50) zwischen zwei benachbarten Plattenteilen gebildet wird, die Materialbrücke, die die elastisch verformbare Verbindung bildet, an einen Schlitz (34) angrenzt, der zwei benachbarte Plattenteile voneinander trennt, und dieser Schlitz insbesondere ermöglicht, dass sich diese zwei benachbarten Plattenteile einander annähern oder voneinander entfernen, wenn die elastisch verformbare Verbindungszone verformt wird.

2. Elektrisches Verbindungsgerät (1) nach dem vorhergehenden Anspruch, bei dem die Positionierungszone (10) an jedem Plattenteil eine Öffnung (17) umfasst, die für den Durchgang eines Positionierungsorgans, wie beispielsweise eines Positionierungsstifts (30), konfiguriert ist, der die Positionierung des Plattenteils mit dem Träger des elektronischen Moduls ermöglicht, wobei dieser Stift beispielsweise metallischer Art ist und mit dem Träger des elektronischen Moduls verbunden ist.

3. Elektrisches Verbindungsgerät (1) nach dem vorhergehenden Anspruch, bei dem jedes Plattenteil (5, 6, 7) mindestens zwei Positionierungszonen (10) aufweist, die insbesondere jeweils durch eine Öffnung (17) gebildet werden.

4. Elektrisches Verbindungsgerät (1) nach einem der vorhergehenden Ansprüche, bei dem das elektrische Verbindungsgerät (1) drei Plattenteile (5, 6, 7) aufweist, die miteinander verbunden sind, eines nach dem anderen, und zwei elastisch verformbare Verbindungen (12; 37), die jeweils so konfiguriert sind, dass sie zwei Plattenteile miteinander verbinden.

5. Elektrisches Verbindungsgerät (1) nach dem vorhergehenden Anspruch, bei dem die elastisch verformbare Verbindung (12; 37) einen Durchgang (18) aufweist, der so konfiguriert ist, dass er gegenüber einer Hohlsäule (104) des Trägers (101) des elektronischen Moduls platziert wird.

6. Elektrisches Verbindungsgerät (1) nach einem der vorhergehenden Ansprüche, bei dem die elastisch verformbare Verbindung mehrere Materialbrücken (50) aufweist, die zwei benachbarte Plattenteile miteinander verbinden.

7. Elektrisches Verbindungsgerät (1) nach einem der vorhergehenden Ansprüche, bei dem die elastisch verformbare Verbindung (12; 37) an einer Ecke des Plattenteils ausgebildet ist, um eine Relativbewegung zwischen zwei benachbarten Plattenteilen um die elastisch verformbare Verbindung herum zu ermöglichen, beispielsweise nach Art eines Drehpunkts.

8. Elektrisches Verbindungsgerät (1) nach einem der vorhergehenden Ansprüche, bei dem die Leiterstäbe (3) insbesondere durch den Kunststoff der Plattenteile umspritzt sind.

9. Elektronisches Modul (100), insbesondere ein Wechselrichter, das ein elektrisches Verbindungsgerät (1) nach einem der vorhergehenden Ansprüche umfasst, das so konfiguriert ist, dass es mit einem Träger (101) des elektronischen Moduls zusammengebaut werden kann, um die elektrische Verbindung der Phasen des elektronischen Moduls sicherzustellen, wobei der Träger (101) insbesondere Positionierungsstifte umfasst, die so konfiguriert sind, dass sie mit Positionierungszonen (10) der Plattenteile (5, 6, 7) zusammenwirken.

10. Verfahren zur Montage eines elektronischen Moduls (100), insbesondere eines Wechselrichters, das ein elektrisches Verbindungsgerät (1) nach einem der Ansprüche 1 bis 8 umfasst, das so konfiguriert ist, dass es mit einem Träger (101) des elektronischen Moduls zusammengebaut werden kann, um die elektrische Verbindung der Phasen des elektronischen Moduls sicherzustellen, wobei der Träger insbesondere Positionierungsstifte (30) umfasst, die so konfiguriert sind, dass sie mit Positionierungszonen der Plattenteile zusammenwirken, wobei das Verfahren den folgenden Schritt umfasst:
- Platzieren der Plattenteile (5, 6, 7) des elektrischen Verbindungsgeräts auf den Positionierungsstiften (30) des Trägers, gegebenenfalls durch Anpassen der relativen Position der Plattenteile (5, 6, 7), damit die Positionierungsstifte den Positionierungszonen der Plattenteile gegenüberliegen.

## Claims

1. Electrical connection device (1) configured to be assembled with a support (101) of an electronic module (100), in particular an inverter, this electrical connection device (1) comprising a body (2), made of plastic material, and electrical conductors (3), in particular in the form of conductive bars which are carried by the body (2), the body comprising at least two plate parts (5, 6, 7) each carrying at least one of the conductors, each plate part (5, 6, 7) comprising at least one positioning zone (10) of the electrical connection device (1) on the support (101), and these plate parts (5, 6, 7) being connected to one another by at least one elastically deformable junction (12) so as to allow placement of one of the plate parts (5, 6, 7) relative to the other part with clearance, when the electrical connection device (1) is assembled on the support (101) of the electronic module, the elastically deformable junction (12; 37) being formed by a material bridge (33; 50) between two neighbouring plate parts, the material bridge forming the elastically deformable junction being adjacent to a slot (34) which separates two neighbouring plate parts, and this slot in particular allows these two neighbouring plate parts to move closer to or further away from one another when the elastically deformable junction zone is deformed.

2. Electrical connection device (1) according to the preceding claim, in which the positioning zone (10) on each plate part comprises an orifice (17) configured for the passage of a positioning member such as a positioning rod (30) which allows the plate part to be positioned with the support of the electronic module, this rod being for example of metallic type, connected to the support of the electronic module.

3. Electrical connection device (1) according to the preceding claim, in which each plate part (5, 6, 7) comprises at least two positioning zones (10), in particular each formed by an orifice (17).

4. Electrical connection device (1) according to one of the preceding claims, in which the electrical connection device (1) comprises three plate parts (5, 6, 7) connected to one another, one after the other, and two elastically deformable junctions (12; 37) each configured to connect two plate parts to one another.

5. Electrical connection device (1) according to the preceding claim, in which the elastically deformable junction (12; 37) comprises a passage (18) configured to be placed in line with a hollow column (104) of the support (101) of the electronic module.

6. Electrical connection device (1) according to one of the preceding claims, in which the elastically deformable junction comprises several material bridges (50) connecting two neighbouring plate parts.

7. Electrical connection device (1) according to one of the preceding claims, in which the elastically deformable junction (12; 37) is formed at a corner of the plate part so as to allow relative movement between two neighbouring plate parts about the elastically deformable junction, for example in the manner of a pivot.

8. Electrical connection device (1) according to one of the preceding claims, in which the conductive bars (3) are in particular overmoulded by the plastic material of the plate parts.

9. Electronic module (100), in particular an inverter, comprising an electrical connection device (1) according to one of the preceding claims, configured to be assembled with a support (101) of the electronic module to ensure the electrical connection of the phases of the electronic module, the support (101) comprising in particular positioning rods configured to cooperate with positioning zones (10) of the plate parts (5, 6, 7).

10. Method of assembling an electronic module (100), in particular an inverter, comprising an electrical connection device (1) according to one of claims 1 to 8, configured to be assembled with a support (101) of the electronic module to ensure the electrical connection of the phases of the electronic module, the support comprising in particular positioning rods (30) configured to cooperate with positioning zones of the plate parts, the method comprising the following step:
- placing the plate parts (5, 6, 7) of the electrical connection device on the positioning rods (30) of the support, optionally by adjusting the relative position of the plate parts (5, 6, 7) so that the positioning rods are aligned with the positioning zones of the plate parts.
